# FASCICULE DE BREVET EUROPEEN

(11) **EP 1 761 968 B1**
(45) Date de publication et mention de la délivrance du brevet: **08.04.2009**
(21) Numéro de dépôt: 05762728.3
(22) Date de dépôt: 17.05.2005
(51) Int. Cl.: H01M 10/48, H01M 8/04

(54) **SYSTEME DE SURVEILLANCE D'UN ENSEMBLE DE CELLULES ELECTROCHIMIQUES ET DISPOSITIF DE REALISATION**
SYSTEM ZUR ÜBERWACHUNG EINER GRUPPE VON ELEKTROCHEMISCHEN ZELLEN UND ZUGEHÖRIGE VORRICHTUNG
SYSTEM FOR MONITORING A GROUP OF ELECTROCHEMICAL CELLS AND DEVICE THEREFOR

(30) Priorité: 16.06.2004 FR 0406523
(43) Date de publication de la demande: 14.03.2007
(73) Titulaire: L'AIR LIQUIDE, Société Anonyme pour l'Etude et l'Exploitation des Procédés Georges Claude, 75007 Paris (FR)
(72) Inventeur: CHARLAT, Pierre, F-38250 LANS EN VERCORS (FR)
(74) Mandataire: De Cuenca, Emmanuel Jaime
(86) Numéro de dépôt international: PCT/FR2005/050332
(87) Numéro de publication internationale: WO 2006/003332

(56) Documents cités:
- WO-A-99/67869
- DE-A1- 10 043 139
- DE-A1- 10 059 392
- DE-A1- 19 907 369
- GB-A- 1 370 996

## Description

La présente invention concerne un système de surveillance d'un ensemble de n cellules électrochimiques disposées en série. Elle concerne également un dispositif de connexion pour la réalisation dudit système de surveillance.

L'invention trouve une application particulièrement avantageuse dans le domaine des piles à combustible composées d'un assemblage de cellules électrochimiques mises électriquement en série.

Chaque cellule d'une pile à combustible délivre une tension continue qui dépend du courant demandé, des conditions de fonctionnement (alimentation en réactifs, humidité, température) et des performances électrochimiques des composants. Cette tension est, en fonctionnement normal, comprise entre une tension minimale de 0,5 V et 1 V.

Toutefois, en raison d'un vieillissement ou d'une sensibilité particulière aux conditions de fonctionnement, il arrive qu'une ou plusieurs cellules de l'ensemble aient une tension très inférieure à ces valeurs, se rapprochant de 0,2 V, voire 0 V, ou des tensions inverses, dites «négatives». Cette tension de fonctionnement faible peut induire un stress thermique supplémentaire accélérant encore le vieillissement, ou favoriser l'apparition de perforations dans la cellule.

Pour résoudre ce problème, on a recours de manière connue à une surveillance des tensions individuelles des cellules.

Rappelons qu'en l'absence d'une telle surveillance, seule la fuite d'hydrogène due à la perforation des cellules est détectée et conduit à la prise en compte de la défaillance.

Par contre, une surveillance des tensions des cellules permet une détection précoce de la défaillance et assure que la réparation se fasse avec le moins de discontinuité possible dans la fourniture de l'énergie au client.

Les systèmes de surveillance actuellement connus sont à base de mesures successives des tensions individuelles des cellules au moyen d'un système d'acquisition relié à chacune des cellules et traité de manière informatique. Le document DE 100 59 392 décrit une pile à combustible dont chacune des cellules est connectée en parrallèle à une diode. Ces systèmes exigent des moyens de mesure complexes et coûteux. Ils sont de plus compliqués par le fait que les mesures différentielles de tensions aux bornes de chaque cellule doivent être effectuées avec des tensions de mode commun très importantes, par exemple 100 V environ pour la tension la plus élevée d'un empilement de 100 cellules, ce qui accroît d'autant les contraintes sur les composants et l'architecture associée.

Enfin, le dispositif de connexion aux cellules est généralement un élément de coût important.

Aussi, le problème technique à résoudre par l'objet de la présente invention est de proposer un système de surveillance d'un ensemble de n cellules électrochimiques disposées en série, chaque cellule étant destinée à délivrer une tension continue supérieure à une valeur minimum, qui permettrait d'obtenir une surveillance des cellules efficace mais cependant plus simple et moins coûteuse qu'avec les systèmes connus.

La solution au problème technique posé consiste, selon la présente invention, en ce que ledit système de surveillance comprend :
- un ensemble correspondant de n composants électroniques disposés en série, chaque composant étant polarisé par la tension continue d'une cellule correspondante au moyen d'un élément de liaison basse-fréquenoe, et présentant une tension de seuil de conductivité au moins égale à ladite valeur minimum,
- un moyen de mesure d'un paramètre de conductivité haute-fréquence de l'ensemble desdits composants.

Ainsi, la mesure dudit paramètre de conductivité haute-fréquence donne-t-elle une visibilité globale sur l'état de fonctionnement de l'ensemble des cellules électrochimiques. En effet, si au moins une cellule de l'ensemble est défaillante au point de fournir une tension inférieure au seuil de conductivité du composant électronique correspondant, une rupture se produira dans la conductivité de la chaîne de composants. Cette rupture, détectée par la mesure du paramètre de conductivité, indiquera une anomalie et provoquera l'intervention du service de maintenance en charge de la batterie de cellules.

L'indication du caractère anormal de la valeur du paramètre de conductivité mesuré est obtenue par le système de surveillance du fait que, selon l'invention, il comprend également un comparateur apte à comparer ledit paramètre de conductivité haute-fréquence à un seuil donné.

Dans un mode de réalisation de l'invention, ledit paramètre de conductivité mesuré est l'impédance haute-fréquence de l'ensemble des composants.

En particulier, l'invention prévoit que lesdits composants électroniques sont des diodes.

Enfin, comme on le verra en détail plus loin, un dispositif de connexion pour la réalisation d'un système de surveillance selon l'invention est notamment remarquable en ce que ledit dispositif est constitué d'un ensemble de n agrafes accolées, chaque agrafe supportant :
- un élément de liaison basse-fréquence dont une extrémité est reliée à une borne d'une cellule correspondante,
- un composant électronique,
et chaque agrafe recevant une extrémité du composant électronique d'une agrafe voisine,
l'autre extrémité de l'élément de liaison basse-fréquence, une extrémité du composant électronique et ladite extrémité du composant électronique voisin étant connectées entre elles.

La description qui va suivre en regard des dessins annexés, donnés à titre d'exemples non limitatifs, fera bien comprendre en quoi consiste l'invention et comment elle peut être réalisée.
La figure 1 est un schéma électrique d'un système de surveillance selon l'invention.
La figure 2 est une vue en perspective d'une agrafe d'un dispositif de connexion pour la réalisation du système de surveillance conforme à l'invention.
La figure 3 est une vue en perspective d'un dispositif de connexion pour la réalisation du système de surveillance conforme à l'invention.
La figure 4 est un schéma d'un circuit électronique de détection de défaillance d'une cellule.

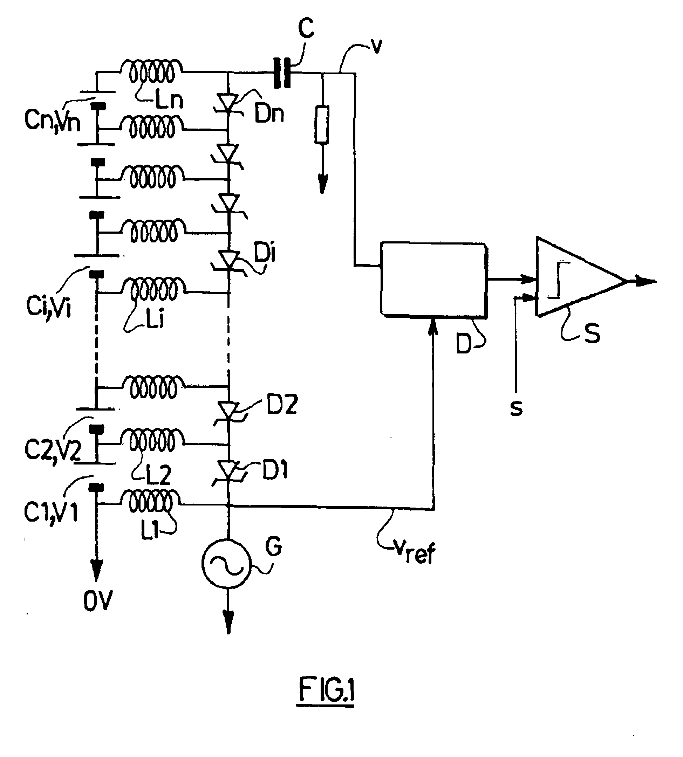

Sur la figure 1 est représenté un système de surveillance d'un ensemble de n cellules électrochimiques disposées en série. Ces cellules, telles que des piles à combustible, sont respectivement référencées C1, C2,..., Ci,..., Cn et délivrent à leurs bornes une tension continue V1, V2,..., Vi,..., Vn dont la valeur en fonctionnement normal est supérieure à une valeur minimale Vmin de 0,2 V par exemple.

Comme on peut le voir sur la figure 1, ledit système de surveillance comprend un ensemble de n composants électroniques qui, dans le mode de réalisation représenté, sont des diodes Schottky D1, D2,..., Di,..., Dn disposées en série. Ces diodes présentent une tension Vs de seuil de conductivité de 0,3 V à 0,6 V, de préférence supérieure à la tension minimum Vmin de fonctionnement des cellules C1, C2,..., Ci,..., Cn.

Le nombre n de diodes est égal au nombre n de cellules à évaluer, chaque cellule Ci étant associée à une diode Di au sens où chaque diode Di est polarisée par la tension Vi de la seule cellule Ci.

La polarisation des diodes est réalisée au moyen d'éléments de liaison basse-fréquence, ici des inductances Li, placés entre la série des cellules Ci et la série des diodes Di. Ces inductances Li sont, à basse-fréquence et donc pour le courant continu, équivalentes à des circuits fermés. Par contre, à des fréquences plus élevées, elles se comportent comme des circuits ouverts et découplent les tensions aux bornes des diodes des tensions continues Vi aux bornes des cellules.

Cette propriété est mise à profit pour effectuer une mesure d'un paramètre de conductivité haute-fréquence de l'ensemble des diodes Di. A cet effet, un générateur G applique aux bornes de la série de diodes une tension alternative de fréquence comprise entre 300 et 5000 kHz, de préférence 1000 à 3000 kHz, et d'amplitude comprise entre 1 et 300 mV, de préférence 20 à 100 mV.

On mesure alors au moyen d'un détecteur D l'impédance, ou le courant, de la série de diodes Di à la fréquence élevée choisie. A ces fréquences, une simple capacité C ou un couplage par inductances mutuelles suffit pour découpler la lecture de l'impédance de la valeur élevée de la tension continue et résout ainsi le problème de « mode commun » évoqué plus haut.

En fonctionnement normal, la tension Vi appliquée à chaque diode Di est supérieure à la tension Vs de seuil et l'impédance de l'ensemble des diodes équivaut à une série de résistances. Par contre, si une ou plusieurs cellules ne présentent plus une tension suffisante pour permettre la polarisation de la diode correspondante, l'impédance mesurée devient celle d'un circuit ouvert.

La valeur obtenue pour l'impédance des diodes est comparée en sortie du détecteur D à un seuil s par un comparateur S afin de permettre de décider si le fonctionnement des cellules est normal ou si un problème se pose. Dans ce cas, il est alors possible de prendre les mesures qui s'imposent : modifications des conditions de fonctionnement jusqu'à retrouver un fonctionnement correct, ou maintenance,...

Quel que soit le paramètre de conductivité mesuré, impédance, courant ou autre, le détecteur D utilisé est avantageusement un détecteur synchrone appliquant une référence vs de fréquence tirée du générateur G au signal v de sortie issu de la série de diodes et appliqué à l'entrée du générateur. Ce type de détection permet de réduire la sensibilité de la mesure aux perturbations.

Les inductances Li choisies sont de inductances axiales de valeur comprises entre 3 et 1000 µH, de préférence 50 à 500 µH.

Les diodes Di sont de type petits signaux, de préférence de type Schottky BAT41, BAT42 ou BAT43 ou des diodes de type 1 N4148.

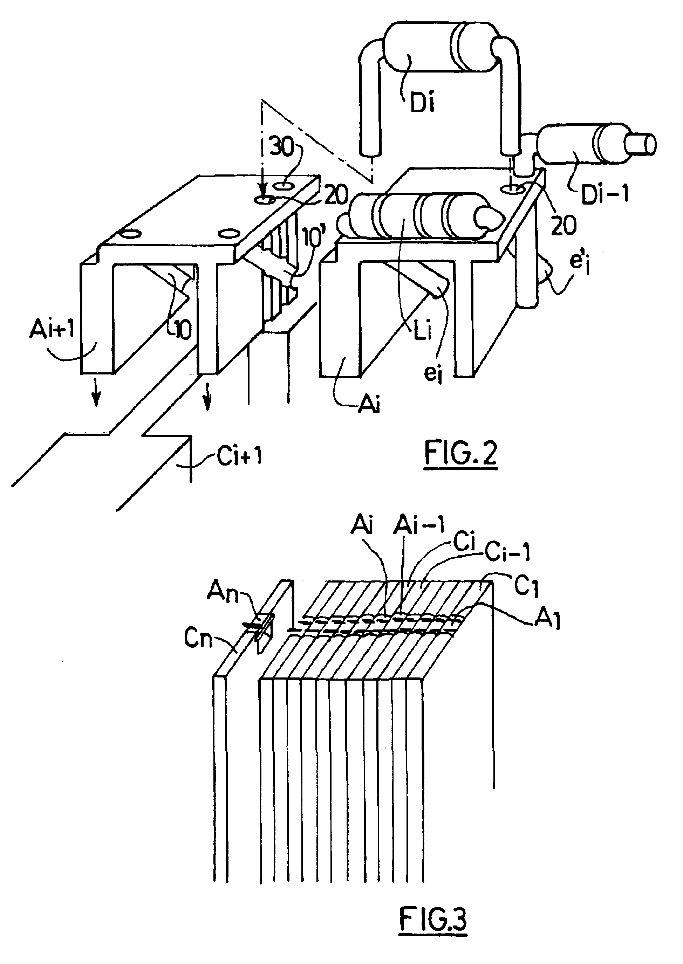

Un dispositif de connexion pour la réalisation du système de surveillance de la figure 1 est illustré sur la figure 2.

L'élément de base de ce dispositif de connexion est constitué par un ensemble de n agrafes Ai, chacune associée à une cellule électrochimique Ci.

Les agrafes Ai sont réalisées en élastomère ou un matériau équivalent (Hytrel, Viton,...). Chaque agrafe Ai supporte, sans soudure, une inductance Li dont une extrémité ei est destinée à être reliée à une borne de la cellule Ci correspondante. Comme l'indique la figure 2, les conducteurs de connexion des inductances sont disposées dans des évidements 10, 10' pratiquées sur les parois des agrafes.

Chaque agrafe Ai reçoit également, toujours sans soudure, une diode Di, un conducteur de connexion de la diode Di étant introduit dans un trou 20 de l'agrafe Ai, l'autre conducteur de connexion étant introduit dans le trou 20 correspondant d'une agrafe Ai+1 voisine.

De même, l'agrafe Ai reçoit à travers un trou 30 un conducteur de connexion de la diode Di-1 d'une autre agrafe Ai-1 voisine. L'autre extrémité e'i de l'inductance ainsi que les conducteurs de connexion des diodes Di et Di-1 débouchent de l'agrafe Ai avec un recouvrement suffisant pour permette de réaliser un contact électrique entre ces trois composants par compression lors de l'assemblage des cellules Ci constituant la batterie de cellules montrée sur la figure 3.

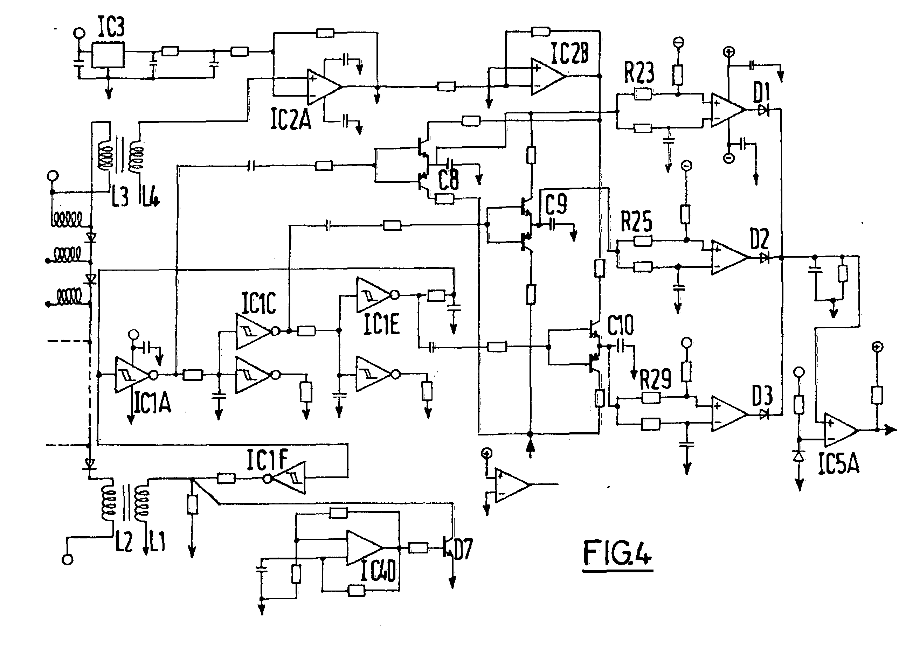

Comme l'indique la figure 4, le circuit électronique de détection de défaillance d'une cellule est constitué d'un ensemble de trois gâchettes de Schmitt IC1A, IC1C, IC1E montées symétriquement avec des résistances et des capacités qui permettent de créer trois signaux carrés de fréquence comprise entre 1,5 et 3 Mhz et en déphasage de 2π/3. L'une de ces phases est injectée par le circuit IC1F dans un ensemble d'inductances mutuelles L1 et L2 formant transformateur, après réduction de son amplitude.

Le signal est alors récupéré par un autre ensemble d'inductances mutuelles L3 et L4, amplifié et additionné d'une constante, créée par le circuit IC3 ou par une diode Zener, par un montage inverseur à amplificateur opérationnel IC2A, avec un amplificateur dont les caractéristiques permettent le travail à des fréquences comprises jusqu'à 10 MHz, par exemple type LM 6172 ou LM 6182. Une deuxième somme, de tension positive, est réalisée par inversion avec le deuxième amplificateur IC2B présent dans le boîtier à amplificateurs.

Chaque phase sert de polarisation à un ensemble de deux transistors qui permettent de charger alternativement une capacité C8, C9, C10. On réalise ainsi une détection à la fréquence précise injectée dans l'ensemble de diodes mises en parallèle des cellules.

L'injection de signal par L1 et L2 est appliquée et supprimée alternativement avec une fréquence de l'ordre de 100 Hz grâce au circuit IC4D et le transistor Q7. Une détection de front montant sur les tensions des capacités C8, C9 et C10, additionnée d'une fonction OU par les diodes D1, D2 et D3, puis un filtrage, permet de créer une sortie par le circuit IC5A dont le seuil de détection peut être ajusté au moyen des résistances R23, R25 et R29.

## Revendications

1. Système de surveillance d'un ensemble de n cellules électrochimiques (C1,..., Ci,..., Cn) disposées en série, chaque cellule (Ci) étant destinée à délivrer une tension continue (Vi) supérieure à une valeur minimum (Vmin), **caractérisé en ce que** ledit système de surveillance comprend :
- un ensemble correspondant de n composants électroniques (D1,..., Di,..., Dn) disposés en série, chaque composant (Di) étant polarisé par la tension continue (Vi) d'une cellule correspondante (Ci) au moyen d'un élément (Li) de liaison basse-fréquence, et présentant une tension de seuil (Vs) de conductivité au moins égale à ladite valeur minimum (Vmin),
- un moyen (D) de mesure d'un paramètre de conductivité haute-fréquence de l'ensemble desdits composants.

2. Système de surveillance selon la revendication 1, **caractérisé en ce qu'**il comprend également un comparateur (S) apte à comparer ledit paramètre de conductivité haute-fréquence à un seuil (s) donné.

3. Système de surveillance selon l'une des revendications 1 ou 2, **caractérisé en ce que** ledit paramètre de conductivité mesuré est l'impédance haute-fréquence de l'ensemble des composants.

4. Système de surveillance selon l'une quelconque des revendications 1 à 3, **caractérisé en ce que** lesdits composants électroniques sont des diodes (Di).

5. Système de surveillance selon l'une quelconque des revendications 1 à 4, **caractérisé en ce que** ledit élément de liaison basse-fréquence est une inductance (Li).

6. Dispositif de connexion pour la réalisation d'un système de surveillance selon l'une quelconque des revendications 1 à 5, **caractérisé en ce que** ledit dispositif est constitué d'un ensemble de n agrafes (A1,..., Ai,..., An) accolées, chaque agrafe (Ai) supportant :
- un élément (Li) de liaison basse-fréquence dont une extrémité (ei) est reliée à une borne d'une cellule correspondante (Ci),
- un composant électronique (Di),
et chaque agrafe (Ai) recevant une extrémité du composant électronique (Di-1) d'une agrafe voisine (Ai-1),
l'autre extrémité (e'i) de l'élément (Li) de liaison basse-fréquence, une extrémité du composant électronique (Di) et ladite extrémité du composant électronique (Di-1) voisin étant connectées entre elles.

7. Dispositif de connexion selon la revendication 6, **caractérisé en ce que** lesdites extrémités sont connectées entre elles par compression.

## Claims

1. System for monitoring a group of n electrochemical cells (C1,..., Ci,..., Cn) disposed in series, each cell (Ci) being designed to deliver a DC voltage (Vi) higher than a minimum value (Vmin), **characterized in that** said monitoring system comprises:
- a corresponding assembly of n electronic components (D1,..., Di,..., Dn) disposed in series, each component (Di) being biased by the DC voltage (Vi) of a corresponding cell (Ci) via a low-frequency connection element (Li), and having a conductivity threshold voltage (Vs) at least equal to said minimum value (Vmin),
- a means (D) for measuring a high-frequency conductivity parameter of the assembly of said components.

2. Monitoring system according to Claim 1, **characterized in that** it also comprises a comparator (S) capable of comparing said high-frequency conductivity parameter with a given threshold (s).

3. Monitoring system according to either of Claims 1 and 2, **characterized in that** said measured conductivity parameter is the high-frequency impedance of the whole of the components.

4. Monitoring system according to any one of Claims 1 to 3, **characterized in that** said electronic components are diodes (Di).

5. Monitoring system according to any one of Claims 1 to 4, **characterized in that** said low-frequency connection element is an inductor (Li).

6. Connection device for the construction of a monitoring system according to any one of Claims 1 to 5, **characterized in that** said device is composed of an assembly of n coupled clips (A1,..., Ai , ... , An), each clip (Ai) supporting:
- a low-frequency connection element (Li) one end of which (ei) is connected to one terminal of a corresponding cell (Ci),
- an electronic component (Di),
and each clip (Ai) receiving one end of the electronic component (Di-1) of a neighboring clip (Ai-1),
the other end (e'i) of the low-frequency connection element (Li), one end of the electronic component (Di) and said end of the neighboring electronic component (Di-1) being connected together.

7. Connection device according to Claim 6, **characterized in that** said ends are connected together by compression.

## Patentansprüche

1. System zur Überwachung einer Gesamtheit von n elektrochemischen Zellen (C1, ..., Ci, ..., Cn), die in Reihe angeordnet sind, wobei jede Zelle (Ci) eine Gleichspannung (Vi) bereitstellen soll, die größer als ein Mindestwert (Vmin) ist, **dadurch gekennzeichnet, dass** dieses Überwachungssystem Folgendes aufweist:
- eine entsprechende Gesamtheit von n elektronischen Komponenten (D1, ..., Di, ..., Dn), die in Reihe angeordnet sind, wobei jede Komponente (Di) durch die Gleichspannung (Vi) einer entsprechenden Zelle (Ci) mittels eines Niederfrequenz-Verbindungselements (Li) polarisiert wird und eine Leitfähigkeits-Schwellenspannung (Vs) aufweist, die mindestens gleich dem Mindestwert (Vmin) ist,
- ein Mittel (D) zur Messung eines Hochfrequenz-Leitfähigkeitsparameters der Gesamtheit dieser Komponenten.

2. System zur Überwachung nach Anspruch 1, **dadurch gekennzeichnet, dass** es ebenfalls einen Komparator (S) aufweist, der den Hochfrequenz-Leitfähigkeitsparameter mit einer gegebenen Schwelle (s) vergleichen kann.

3. System zur Überwachung nach einem der Ansprüche 1 oder 2, **dadurch gekennzeichnet, dass** der gemessene Leitfähigkeitsparameter die Hochfrequenz-Impedanz der Gesamtheit von Komponenten ist.

4. System zur Überwachung nach einem der Ansprüche 1 bis 3, **dadurch gekennzeichnet, dass** die elektronischen Komponenten Dioden (Di) sind.

5. System zur Überwachung nach einem der Ansprüche 1 bis 4, **dadurch gekennzeichnet, dass** das Niederfrequenz-Verbindungselement eine Induktivität (Li) ist.

6. Verbindungsvorrichtung zur Verwirklichung eines Überwachungssystems nach einem der Ansprüche 1 bis 5, **dadurch gekennzeichnet, dass** die Vorrichtung aus einer Gesamtheit von n Klammern (A1, ..., Ai, ..., An) gebildet ist, wobei jede Klammer (Ai) Folgendes stützt:
- ein Niederfrequenz-Verbindungselement (Li), wovon ein Ende (ei) an einer Klemme einer entsprechenden Zelle (Ci) angeschlossen ist,
- eine elektronische Komponente (Di),
und wobei jede Klammer (Ai) ein Ende der elektronischen Komponente (Di-1) einer benachbarten Klammer (Ai-1) aufnimmt,
das andere Ende (e'i) des Niederfrequenz-Verbindungselements (Li), ein Ende der elektronischen Komponente (Di) und das Ende der benachbarten elektronischen Komponente (Di-1) untereinander verbunden sind.

7. Verbindungsvorrichtung nach Anspruch 6, **dadurch gekennzeichnet, dass** die Enden durch Druck untereinander verbunden sind.
